# EUROPÄISCHE PATENTANMELDUNG

(11) **EP 4 321 390 A1**
(43) Veröffentlichungstag der Anmeldung: **14.02.2024**
(21) Anmeldenummer: 23190202.4
(22) Anmeldetag: 08.08.2023
(51) Int. Cl.: B60R 16/02, B64G 1/42

(54) **SYSTEM ZUR STROMÜBERTRAGUNG INNERHALB EINES FAHRZEUGS UND VERFAHREN ZUM BETRIEB DES SYSTEMS**

(30) Priorität: 10.08.2022 DE 102022120195
(71) Anmelder: Yazaki Systems Technologies GmbH, 93059 Regensburg (DE)
(72) Erfinder: CHAU, Thanh Qui, 93053 Regensburg (DE); EINERT, Martin, 93077 Bad Abbach (DE); SMOLARCZYK, Matthias, 93059 Regensburg (DE)
(74) Vertreter: Patentanwaltskanzlei WILHELM & BECK

(57) **Zusammenfassung**

System (10) zur Stromübertragung innerhalb eines Fahrzeugs und Verfahren zum Betrieb des Systems (10), wobei das System (10) einen thermoelektrischen Generator (25) und ein elektrisches Bordnetz (30) mit wenigstens einem ersten elektrischen Leiter (55) aufweist, wobei der thermoelektrische Generator (25) eine Ausgangsseite (75) aufweist, die elektrisch mit einer elektrischen Energiequelle (40) des Fahrzeugs verbindbar ist, wobei der thermoelektrische Generator (25) direkt oder indirekt thermisch mit dem ersten elektrischen Leiter (55) verbunden ist, wobei der erste elektrische Leiter (55) ausgebildet ist, eine erste elektrische Energie zu übertragen und auf Grund der Übertragung der ersten elektrischen Energie eine Wärme (Q) bereitzustellen, wobei der thermoelektrische Generator (25) ausgebildet ist, die Wärme (Q) von zumindest dem ersten elektrischen Leiter (55) aufzunehmen und in eine zweite elektrische Energie umzuwandeln, wobei der thermoelektrische Generator (25) ausgebildet ist, die zweite elektrische Energie an der Ausgangsseite (75) zur Einspeisung in das elektrische Bordnetz (30) bereitzustellen.

## Beschreibung

Die Erfindung betrifft ein System zur Stromübertragung innerhalb eines Fahrzeugs gemäß Patentanspruch 1 und ein Verfahren zum Betrieb des Systems gemäß Patentanspruch 15.

Aus der DE 10 2016 108 522 A1 ist Kabelbaum mit einer Schaumummantelung bekannt.

Es ist Aufgabe der Erfindung, ein verbessertes System zur Stromübertragung innerhalb eines Fahrzeugs und ein verbessertes Verfahren zum Betrieb des Systems bereitzustellen.

Diese Aufgabe wird mittels eines Systems gemäß Patentanspruch 1 und mittels eines Verfahrens gemäß Patentanspruch 15 gelöst. Vorteilhafte Ausführungsformen sind in den abhängigen Ansprüchen angegeben.

Es wurde erkannt, dass ein verbessertes System zur Stromübertragung innerhalb eines Fahrzeugs dadurch bereitgestellt werden kann, dass das System einen thermoelektrischen Generator und ein Bordnetz mit wenigstens einem ersten elektrischen Leiter zur Stromübertragung aufweist. Der thermoelektrische Generator weist eine Ausgangsseite auf, die elektrisch mit einer elektrischen Energiequelle des Fahrzeugs verbindbar ist. Der thermoelektrische Generator ist direkt oder indirekt thermisch mit dem ersten elektrischen Leiter verbunden. Der erste elektrische Leiter ist ausgebildet, eine erste elektrische Energie zu übertragen und auf Grund der Übertragung der ersten elektrischen Energie eine Wärme zu erzeugen. Der thermoelektrische Generator ist ausgebildet, die Wärme von zumindest dem ersten elektrischen Leiter aufzunehmen und in eine zweite elektrische Energie umzuwandeln. Der thermoelektrische Generator ist weiter ausgebildet, die zweite elektrische Energie an der Ausgangsseite zur Einspeisung in das elektrische Bordnetz bereitzustellen.

Diese Ausgestaltung hat den Vorteil, dass die zweite elektrische Energie weiter genutzt werden kann. Insbesondere kann die zweite elektrische Energie dazu genutzt werden, eine durch die elektrische Energiequelle bereitgestellte elektrische Quellenenergie durch Einspeisung der zweiten elektrischen Energie in den ersten elektrischen Leiter zu reduzieren. Ferner kann durch den thermoelektrischen Generator der erste elektrische Leiter gekühlt werden und dadurch eine Stromtragfähigkeit des ersten elektrischen Leiters, insbesondere eine Hochstromtragfähigkeit des ersten elektrischen Leiters, verbessert werden.

In einer weiteren Ausführungsform ist das System vorzugsweise als Kabelbaum ausgebildet. Das Bordnetz des Systems weist einen Kabelbaum mit einem Kabelbündel mit wenigstens einem ersten elektrischen Kabel und einem zweiten elektrischen Kabel auf. Das erste elektrische Kabel weist den ersten elektrischen Leiter und eine erste Isolierung auf, die den ersten elektrischen Leiter elektrisch isoliert. Das zweite elektrische Kabel weist einen zweiten elektrischen Leiter zur Stromübertagung und eine zweite Isolierung auf, die den zweiten elektrischen Leiter elektrisch isoliert. Der thermoelektrische Generator ist sowohl thermisch mit dem ersten elektrischen Leiter als auch mit dem zweiten elektrischen Leiter verbunden und ist ausgebildet, den ersten elektrischen Leiter und zweiten elektrischen Leiter zu kühlen. Diese Ausgestaltung hat den Vorteil, dass eine ungewollte Überhitzung des ersten und/oder zweiten elektrischen Leiters durch den thermoelektrischen Generator zuverlässig vermieden werden kann.

In einer weiteren Ausführungsform weist das System eine Schaumummantelung auf. Das Kabelbündel ist zumindest abschnittsweise, vorzugsweise vollständig, in der Schaumummantelung eingebettet. Die Schaumummantelung verbindet mechanisch das erste elektrische Kabel mit dem zweiten elektrischen Kabel. Der thermoelektrische Generator liegt vorzugsweise zumindest an einem der elektrischen Kabel des Kabelbündels an. Alternativ oder zusätzlich kann der thermoelektrische Generator thermisch über die Schaumummantelung mit zumindest einem der elektrischen Kabel verbunden sein. Dadurch kann der thermoelektrische Generator zusätzlich auch in der Schaumummantelung eingebettet sein, sodass eine thermische Isolierung des Kabelbündels von dem thermoelektrischen Generator vermieden werden kann. Ferner ist dadurch die bereitgestellte zweite elektrische Energie durch den thermoelektrischen Generator besonders groß.

In einer weiteren Ausführungsform weist das System einen DC-Wandler auf, wobei der DC-Wandler zwischen der Ausgangsseite und dem thermoelektrischen Generator angeordnet ist. Der DC-Wandler weist eine Wandlereingangsseite und eine Wandlerausgangsseite auf, wobei die Wandlereingangsseite elektrisch mit der Ausgangsseite des thermoelektrischen Generators verbunden ist. Die Wandlerausgangsseite ist elektrisch mit dem Bordnetz des Fahrzeugs gekoppelt. Der DC-Wandler ist ausgebildet, eine an der Wandlereingangsseite anliegende Spannung der zweiten elektrischen Energie auf eine an der Wandlerausgangsseite anliegende vordefinierte Ausgangsspannung zu wandeln. Diese Ausgestaltung hat den Vorteil, dass die an der Wandlereingangsseite anliegende Spannung variieren kann, insbesondere in Abhängigkeit der vom ersten elektrischen Leiter produzierten Wärme, und ausgangsseitig an der Wandlerausgangsseite die gewünschte vordefinierte Ausgangsspannung anliegt. Die vordefinierte Ausgangsspannung kann dabei vorzugsweise die Spannung sein, die die erste elektrische Energie aufweist.

In einer weiteren Ausführungsform weist der thermoelektrische Generator eine Anordnung aus wenigstens einem ersten Generatorelement und einem zweiten Generatorelement auf, wobei das erste Generatorelement und das zweite Generatorelement unterschiedlich zueinander dotiert sind. Das erste Generatorelement und das zweite Generatorelement sind dabei elektrisch in Reihe zueinander geschaltet. Diese Ausgestaltung hat den Vorteil, dass die an der Wandlereingangsseite anliegende Spannung besonders hoch ist.

In einer weiteren Ausführungsform weist der thermoelektrische Generator eine flexible Leiterplatte auf, wobei wenigstens eine Leiterbahn der flexiblen Leiterplatte das erste Generatorelement mit dem zweiten Generatorelement verbindet. Dadurch kann der thermoelektrische Generator besonders einfach an einem Kabelbaum des Systems befestigt werden und an die geometrische Ausgestaltung des Kabelbaums oder einer anderen Komponente des Systems zur Kühlung der Komponente angepasst werden.

In einer weiteren Ausführungsform weist die flexible Leiterplatte eine erste Trägerschicht und zweite Trägerschicht auf, wobei die erste Trägerschicht und die zweite Trägerschicht jeweils elastisch und elektrisch isolierend ausgebildet sind. Zwischen der ersten Trägerschicht und der zweiten Trägerschicht sind das erste und zweite Generatorelement angeordnet. Diese Ausgestaltung hat den Vorteil, dass der thermoelektrische Generator besonders dünn ausgebildet ist.

In einer weiteren Ausführungsform weist das System eine erste Isolierung auf, wobei die erste Isolierung an dem ersten elektrischen Leiter angeordnet ist und den ersten elektrischen Leiter ummantelt. Die erste Isolierung ist einstückig und materialeinheitlich mit der ersten Trägerschicht ausgebildet. Diese Ausgestaltung hat den Vorteil, dass der thermoelektrische Generator besonders nah dem ersten elektrischen Leiter angeordnet ist und gleichzeitig die elektrische Isolierung des ersten elektrischen Leiters sichergestellt ist.

In einer weiteren Ausführungsform ist der thermoelektrische Generator schlauchförmig und/oder hohlzylinderförmig oder bandförmig ausgebildet. Zusätzlich oder alternativ ist der erste elektrische Leiter als Flachleiter, insbesondere als Busbar oder Batterieleitung, ausgebildet. Diese Ausgestaltung hat den Vorteil, dass in der bandförmigen Ausgestaltung des thermoelektrischen Generators dieser besonders einfach um den elektrischen Leiter herum gewickelt werden kann. Die schlauchförmige Ausgestaltung bietet die Möglichkeit, den thermoelektrischen Generator einfach auf den Kabelbaum oder ein elektrisches Kabel mit dem ersten elektrischen Leiter beispielsweise aufzuschieben.

Von besonderem Vorteil ist, wenn der erste elektrische Leiter eine Leiteraußenseite aufweist, wobei der thermoelektrische Generator auf der Leiteraußenseite angeordnet ist. Dadurch ist eine Wärmeübertragungsfähigkeit zwischen der durch den elektrischen Leiter erzeugten Wärme und dem thermoelektrischen Generator zur Erzeugung der zweiten elektrischen Energie aus der Wärme besonders kurz.

In einer weiteren Ausführungsform weist der erste elektrische Leiter eine Leiteraußenseite auf, wobei die erste Isolierung auf der Leiteraußenseite angeordnet ist und den ersten elektrischen Leiter elektrisch isoliert. Auf einer vom ersten elektrischen Leiter abgewandten Seite der ersten Isolierung ist der thermoelektrische Generator, vorzugsweise in direktem Kontakt mit der ersten Isolierung, angeordnet. Dadurch kann eine gute elektrische Isolierung des ersten elektrischen Leiters sichergestellt werden. Insbesondere ist dies von Vorteil, wenn die an dem ersten elektrischen Leiter anliegende Spannung eine Hochspannung größer 100 Volt ist.

In einer weiteren Ausführungsform ist der thermoelektrische Generator bandförmig ausgebildet und um das Kabelbündel umfangsseitig herumgeführt, insbesondere gewickelt. Der thermoelektrische Generator verbindet dabei mechanisch das erste elektrische Kabel mit dem zweiten elektrischen Kabel. Diese Ausgestaltung hat den Vorteil, dass der thermoelektrische Generator zusätzlich die Funktion der Ummantelung, insbesondere der Wicklung, des Kabelbaums übernimmt und dadurch der Kabelbaum besonders einfach und kostengünstig hergestellt werden kann.

In einer weiteren Ausführungsform weist das System ein Gehäuse auf. Ferner weist das Bordnetz eine Leistungselektronik auf, wobei die Leistungselektronik den ersten elektrischen Leiter aufweist. Das Gehäuse ist thermisch leitfähig ausgebildet und ist thermisch mit dem ersten elektrischen Leiter und dem thermoelektrischen Generator verbunden. An dem Gehäuse ist der thermoelektrische Generator angeordnet und das Gehäuse verbindet thermisch den ersten elektrischen Leiter mit dem thermoelektrischen Generator. Diese Ausgestaltung hat den Vorteil, dass das Gehäuse und somit über das Gehäuse auch die Leistungselektronik aktiv durch den thermoelektrischen Generator gekühlt wird und die durch die Leistungselektronik erzeugte Wärme genutzt werden kann, um die erste elektrische Energie mittels der erzeugten zweiten elektrischen Energie zu reduzieren.

In einer weiteren Ausführungsform weist das System eine elektrische Energiequelle und ein Leistungsterminal auf, das mit der elektrischen Energiequelle elektrisch verbunden ist. Die elektrische Energiequelle ist ausgebildet, am Leistungsterminal eine Quellenenergie bereitzustellen, wobei der erste elektrische Leiter mit dem Leistungsterminal elektrisch verbunden ist, wobei die Ausgangsseite mit dem Leistungsterminal elektrisch gekoppelt ist, wobei die zweite elektrische Energie gemeinsam mit der elektrischen Quellenenergie als erste elektrische Energie in den ersten elektrischen Leiter einspeisbar sind.

Die Aufgabe wird aber auch durch ein Verfahren zum Betrieb des oben beschriebenen Systems dadurch gelöst, dass über den ersten elektrischen Leiter die erste elektrische Energie übertragen wird. Dabei erwärmt sich der erste elektrische Leiter insbesondere auf Grund seines ohmschen Widerstands und stellt die Wärme bereit, wobei die Wärme vom ersten elektrischen Leiter zu dem thermoelektrischen Generator übertragen wird, wobei der thermoelektrische Generator die bereitgestellte Wärme aufnimmt und in die zweite elektrische Energie umwandelt, wobei die zweite elektrische Energie in das Bordnetz eingespeist wird.

Nachfolgend wird die Erfindung anhand von Figuren näher erläutert. Dabei zeigen:
- Figur 1: eine schematische Darstellung eines Systems gemäß einer ersten Ausführungsform;
- Figur 2: eine Schnittansicht entlang einer in Figur 1 gezeigten Schnittebene A-A durch den thermoelektrischen Generator und den Kabelbaum;
- Figur 3: ein Ablaufdiagramm eines Verfahrens zum Betrieb des in den Figuren 1 und 2 beschriebenen Systems gemäß der ersten Ausführungsform;
- Figur 4: eine schematische Darstellung eines Längsschnitts durch den ersten elektrischen Leiter und den thermoelektrischen Generator eines Systems gemäß einer zweiten Ausführungsform;

- Figur 5: eine Schnittansicht entlang einer in Figur 4 gezeigten Schnittebene B-B durch das in Figur 4 gezeigte System;
- Figur 6: einen schematischen Längsschnitt durch einen Kabelabschnitt eines Kabelbaums und den thermoelektrischen Generator eines Systems gemäß einer dritten Ausführungsform;
- Figur 7: einen Ausschnitt eines Längsschnitts durch den Kabelbaum mit dem am Kabelbaum angeordneten thermoelektrischen Generator eines Systems gemäß einer vierten Ausführungsform;
- Figur 8: eine schematische Darstellung des in Figur 7 gezeigten thermoelektrischen Generators in demontiertem Zustand; und
- Figur 9: eine schematische Darstellung eines Systems gemäß einer fünften Ausführungsform.

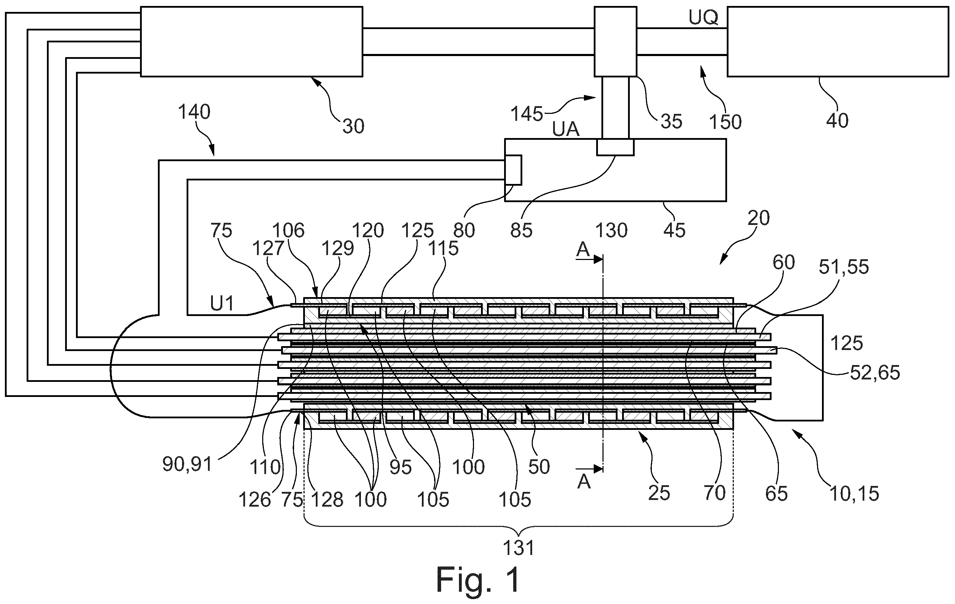

Figur 1 zeigt eine schematische Darstellung eines Systems 10 gemäß einer ersten Ausführungsform.

Das System 10 ist zur Stromübertragung innerhalb eines Fahrzeugs, insbesondere innerhalb eines Kraftfahrzeugs, ausgebildet. Das System 10 weist beispielhaft einen thermoelektrischen Generator 25, ein elektrisches Bordnetz 30 mit einem Kabelbaum 20, ein Leistungsterminal 35, eine elektrische Energiequelle 40 und vorzugsweise einen DC-Wandler 45 auf.

Der Kabelbaum 20 des elektrischen Bordnetzes 30 dient dazu, einzelne Komponenten (in Figur 1 nicht dargestellt) des Fahrzeugs, beispielsweise Steuergeräte und/oder Antriebe, Sensoren oder Ähnliches miteinander elektrisch zu verbinden.

Der Kabelbaum 20 weist beispielhaft ein Kabelbündel 50 mit vorzugsweise einem ersten elektrischen Kabel 51 und wenigstens einem zweiten elektrischen Kabel 52 auf. Insbesondere kann das Kabelbündel 50 eine Vielzahl von elektrischen Kabeln 51, 52 aufweisen, deren Anzahl im Wesentlichen nur durch den Bauraum und gegebenenfalls das Gewicht des Kabelbündels 50 limitiert ist.

Das erste elektrische Kabel 51 und/oder das zweite elektrische Kabel 52 sind vorzugsweise ausgebildet, eine erste elektrische Energie zur Leistungsübertragung zu übertragen. Unter einer Leistungsübertragung wird verstanden, dass über das elektrische Kabel 51, 52 wenigstens ein elektrischer Strom von wenigstens 5 Ampere, insbesondere wenigstens 10 Ampere, insbesondere wenigstens 30 Ampere, insbesondere wenigstens 50 Ampere, insbesondere wenigstens 100 Ampere und kleiner 200 Ampere, insbesondere kleiner 500 Ampere, kleiner 1000 Ampere, bei Übertragung der ersten elektrischen Energie fließt.

Insbesondere wird die erste elektrische Energie über wenigstens einen Zeitraum von 1 Sekunde, insbesondere wenigstens 5 Sekunden, insbesondere wenigstens 10 Sekunden, insbesondere wenigstens 30 Sekunden, insbesondere wenigstens 1 Minute übertragen, sodass in der Ausführungsform hier nicht von einem kurzzeitigen Impuls der ersten elektrischen Energie gesprochen wird, sondern die erste elektrische Energie im Wesentlichen über das wenigstens angegebene Zeitintervall über das jeweilige elektrische Kabel 51, 52 übertragen wird.

Durch die Übertragung der ersten elektrischen Energie über das elektrische Kabel 51, 52, die in der Ausführungsform beispielhaft über das erste elektrische Kabel 51 übertragbar ist, erwärmt sich das jeweilige elektrische Kabel 51, 52, beispielsweise in der Ausführungsform das erste elektrische Kabel 51.

In der Ausführungsform sind das erste elektrische Kabel 51 und das zweite elektrische Kabel 52 des Kabelbündels 50 mittels einer Ummantelung 90 des Kabelbaums 20 miteinander mechanisch verbunden. Die Ummantelung 90 kann beispielsweise umfangsseitig um die elektrischen Kabel 51, 52 des Kabelbündels 50 gewickelt sein. Auch kann die Ummantelung 90 als Schaumummantelung 91 ausgebildet sein. Die Schaumummantelung 91 umschließt in zumindest einem Teilbereich des Kabelbaums 20 die elektrischen Kabel 51, 52 des Kabelbündels 50 umfangsseitig. Von besonderem Vorteil ist, wenn das elektrische Kabel 51, 52, insbesondere das Kabelbündel 50, vorzugsweise vollständig, in der Schaumummantelung 91 eingebettet ist. Dabei wird unter einem Einbetten verstanden, dass umfangsseitig das jeweilige Kabel 51, 52 des Kabelbündels 50 durch einen Schaumwerkstoff der Schaumummantelung 91 umfangsseitig umschlossen ist. Insbesondere kann die Ummantelung 90, insbesondere die Schaumummantelung 91, stoffschlüssig die Kabel 51, 52 miteinander mechanisch verbinden.

Die Schaumummantelung 91 weist wenigstens einen der folgenden ersten Werkstoffe auf: Polyurethan, Polyurethan-Schaum, Silikon, Silikon-Schaum, geschlossenporigen Schaum, gemischt-porigen Schaum, offenporigen Schaum.

Das erste elektrische Kabel 51 weist einen ersten elektrischen Leiter 55 und eine erste Isolierung 60 auf. Der erste elektrische Leiter 55 dient dazu, die oben beschriebene erste elektrische Energie zu übertragen und weist vorzugsweise Kupfer und/oder Aluminium auf. Das zweite elektrische Kabel 52 weist einen zweiten elektrischen Leiter 65 und eine zweite Isolierung 70 auf, wobei der zweite elektrische Leiter 65 ebenso wie der erste elektrische Leiter 55 elektrisch leitend ausgebildet ist, um die erste elektrische Energie zu übertragen. Dabei kann beispielsweise der erste elektrische Leiter 55 als Hinleiter und der zweite elektrische Leiter 65 als Rückleiter für ein Gleichstromsystem ausgebildet sein.

Die erste Isolierung 60 isoliert den ersten elektrischen Leiter 55 elektrisch. Die zweite Isolierung 70 isoliert den zweiten elektrischen Leiter 65. Dabei umschließt jeweils die Isolierung 60, 70 den jeweiligen elektrischen Leiter 55, 65 umfangsseitig. Die erste und/oder zweite Isolierung 60, 70 weist vorzugweise ein elastisches Dielektrikum auf. Ferner wird darauf hingewiesen, dass das erste elektrische Kabel 51 und/oder das zweite elektrische Kabel 52 auch als geschirmtes Kabel ausgebildet sein kann. Auf die Darstellung einer Schirmung wurde in den Figuren verzichtet.

Außenseitig zu der Ummantelung 90 ist der thermoelektrische Generator 25 angeordnet. Dabei liegt der thermoelektrische Generator 25 an einer äußeren Umfangsseite 130 der Ummantelung 90 an und ist vorzugsweise mechanisch, insbesondere stoffschlüssig und/oder formschlüssig, mit der Ummantelung 90 verbunden. Der thermoelektrische Generator 25 kann beispielsweise teilweise oder vollständig einen Kabelabschnitt 131 des Kabelbaums 20 umschließen.

Der thermoelektrische Generator 25 weist eine elektrische Ausgangsseite 75 auf. Der DC-Wandler 45 weist eine Wandlereingangsseite 80 und eine Wandlerausgangsseite 85 auf. Der DC-Wandler 45 ist über die Wandlereingangsseite 80 und eine erste elektrische Verbindung 140 mit der Ausgangsseite 75 des thermoelektrischen Generators 25 elektrisch verbunden. Über eine zweite elektrische Verbindung 145 ist die Wandlerausgangsseite 85 mit dem Leistungsterminal 35 elektrisch verbunden. Das Leistungsterminal 35 ist seinerseits an das elektrische Bordnetz 30 elektrisch angeschlossen und über eine dritte elektrische Verbindung 150 elektrisch mit der elektrischen Energiequelle 40 verbunden.

Es wird darauf hingewiesen, dass insbesondere die dritte elektrische Verbindung 150 auch Teil der elektrischen Energiequelle 40 sein kann. Insbesondere kann die dritte elektrische Verbindung 150 auch eine Zellkontaktierung oder ein Zellkontaktierungssystem sein. Das Leistungsterminal 35 dient dazu, um einerseits die elektrische Energiequelle 40, aber auch andererseits die Wandlerausgangsseite 85 des DC-Wandlers 45 elektrisch anzubinden. Das Leistungsterminal 35 kann aber auch Teil eines Steuergeräts, insbesondere eines Fahrzeugsteuergeräts, oder eine Anschlussschiene sein.

Der thermoelektrische Generator 25 ist in Figur 1 beispielhaft dargestellt. Der thermoelektrische Generator 25 weist eine Anordnung 95 aus beispielhaft einem ersten Generatorelement 100 und einem zweiten Generatorelement 105 auf. Ferner weist der thermoelektrische Generator 25 eine flexible Leiterplatte 106 auf. Die flexible Leiterplatte 106 kann mehrschichtig ausgebildet sein.

In der Ausführungsform weist die flexible Leiterplatte 106 eine erste Trägerschicht 110 und beispielhaft eine zweite Trägerschicht 115 auf. Die erste und/oder die zweite Trägerschicht 110, 115 sind elastisch reversibel verformbar und elektrisch isolierend ausgebildet. Die erste Trägerschicht 110 und die zweite Trägerschicht 115 sind beabstandet zueinander angeordnet. Die erste Trägerschicht 110 liegt an der äußeren Umfangsseite 130 der Ummantelung 90 beispielsweise an. Insbesondere kann die erste Trägerschicht 110 mechanisch an der Ummantelung 90 befestigt, insbesondere angeklebt sein. Dabei ist auf der ersten Trägerschicht 110 auf der zur zweiten Trägerschicht 115 zugewandten Seite beispielhaft eine erste Leiterbahn 120, insbesondere eine Mehrzahl von ersten Leiterbahnen 120, der flexiblen Leiterplatte 106 angeordnet.

Auf der zweiten Trägerschicht 115 weist die flexible Leiterplatte 106 wenigstens eine zweite Leiterbahn 125, insbesondere mehrere zweite Leiterbahnen 125 auf, die auf der zur ersten Trägerschicht 110 zugewandten Seite angeordnet sind. Das erste Generatorelement 100 und das zweite Generatorelement 105 sind beabstandet in Kabellängsrichtung bezogen auf das Kabel 51, 52 zueinander angeordnet. Dabei verbinden abwechselnd die erste Leiterbahn 120 und die zweite Leiterbahn 125 das erste Generatorelement 100 und das zweite Generatorelement 105. Dadurch sind das erste Generatorelement 100 und das zweite Generatorelement 105 in Reihenschaltung zueinander geschaltet.

Das erste Generatorelement 100 und das zweite Generatorelement 105 sind jeweils dotiert. Dabei kann das erste Generatorelement 100 beispielsweise eine positive Dotierung aufweisen. Das zweite Generatorelement 105 weist eine gegenteilige Dotierung zu dem ersten Generatorelement 100 auf. So kann beispielsweise das zweite Generatorelement 105 eine negative Dotierung aufweisen.

Die erste Leiterbahn 120 verbindet jeweils das erste Generatorelement 100 mit dem zweiten Generatorelement 105 auf der ersten Trägerschicht 110 elektrisch. Die zweite Leiterbahn 125 verbindet jeweils das erste Generatorelement 100 mit dem zweiten Generatorelement 105 auf der zweiten Trägerschicht 115 elektrisch.

Eine dritte Leiterbahn 128, die auf der ersten Trägerschicht 110 angeordnet sein kann, ist an einem ersten Anschlusspunkt 126 der Ausgangsseite 75 angeschlossen und verbindet das zweite Generatorelement 105 mit dem ersten Anschlusspunkt 126. Eine vierte Leiterbahn 129, die auf der zweiten Trägerschicht 115 angeordnet sein kann, ist an einem zweiten Anschlusspunkt 127 der Ausgangsseite 75 angeschlossen und verbindet das erste Generatorelement 100 mit dem zweiten Anschlusspunkt 127. Dadurch sind das erste Generatorelement 100 und das zweite Generatorelement 105 über die Ausgangsseite 75 in Reihenschaltung elektrisch mit der Wandlereingangsseite 80 verbunden.

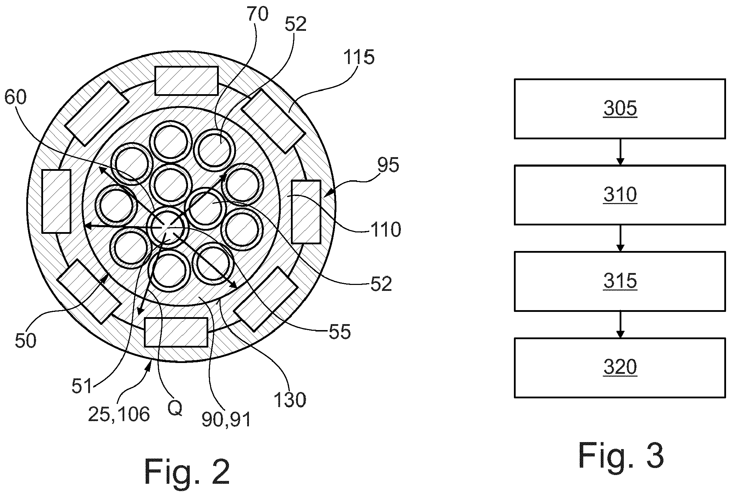

Figur 2 zeigt eine Schnittansicht entlang einer in Figur 1 gezeigten Schnittebene A-A durch den thermoelektrischen Generator 25 und den Kabelbaum 20.

Der thermoelektrische Generator 25 kann beispielsweise schlauchförmig und/oder hohlzylindrisch ausgebildet sein und umfangsseitig vollständig die Ummantelung 90 umschließen

In Figur 2 ist deutlich zu erkennen, dass beispielhaft die Ummantelung 90 vollständig das erste und zweite elektrische Kabel 51, 52 des Kabelbündels 50 umschließt und dadurch das Kabelbündel 50 vollständig in der Ummantelung 90 eingebettet ist. Dadurch wird ein besonders guter und sicherer Verbund des ersten und zweiten elektrischen Kabels 51, 52 sichergestellt.

In der ersten Ausführungsform liegt an der äußeren Umfangsseite 130 der Ummantelung 90 die erste Trägerschicht 110 der flexiblen Leiterplatte 106 an. Außenseitig zu der ersten Trägerschicht 110 ist die Anordnung 95 in Umfangsrichtung herum um das Kabelbündel 50 angeordnet. Außenseitig zu der Anordnung 95 ist die zweite Trägerschicht 115 angeordnet, die die Anordnung 95 gegenüber der Umgebung elektrisch isoliert.

Der thermoelektrische Generator 25 ist über die Ummantelung 90 thermisch mit dem ersten elektrischen Leiter 55 und dem zweiten elektrischen Leiter 65 verbunden. Von besonderem Vorteil ist, wenn die Isolierung 60, 70 und/oder die Ummantelung 90 einen thermisch leitfähigen, jedoch elektrisch isolierenden Werkstoff aufweisen. Dadurch kann die Wärmeübertragung zwischen dem elektrischen Leiter 55, 65 und dem thermoelektrischen Generator 25 erhöht werden.

Figur 3 zeigt ein Ablaufdiagramm eines Verfahrens zum Betrieb des in den Figuren 1 und 2 beschriebenen Systems 10 gemäß der ersten Ausführungsform.

In einem ersten Verfahrensschritt 305 stellt die elektrische Energiequelle 40 eine elektrische Quellenenergie mit der Quellenspannung UQ bereit. Die Quellenenergie entspricht im ersten Verfahrensschritt 305 der ersten elektrischen Energie. Die erste elektrische Energie wird über die dritte elektrische Verbindung 150 zum Leistungsterminal 35 und vom Leistungsterminal 35 über das erste und/oder zweite Kabel 51, 52 übertragen. Bei der Übertragung der ersten elektrischen Energie erwärmt sich jeweils das die erste elektrische Energie übertragende elektrische Kabel 51, 52 aufgrund seines ohmschen Widerstands. Das elektrische Kabel 51, 52 bildet eine Wärmequelle aus und erzeugt eine Wärme Q.

Durch die Einbettung des ersten elektrischen Kabels 51 und des zweiten elektrischen Kabels 52 in die Ummantelung 90, insbesondere in die Schaumummantelung 91, ist das elektrische Kabel 51, 52 gegenüber einer Umgebung thermisch isoliert. In der Auslegung eines Querschnitts des elektrischen Leiters 55, 65 des jeweiligen elektrischen Kabels 51, 52 wird dies üblicherweise dahingehendberücksichtigt, dass ein Querschnitt des jeweiligen elektrischen Leiters 55, 65 vergrößert wird (verglichen mit einem gewickelten Kabelbaum 20), um die Erwärmung des jeweiligen elektrischen Leiters 55, 65 gering zu halten. Dies führt dazu, dass die elektrischen Kabel 51, 52, wenn die elektrischen Kabel 51, 52 in der Schaumummantelung 91 eingebettet sind, schwerer sind, und insgesamt das Bordnetz 30 bei einem konventionellen Kabelbaum mit eingebetteten Kabeln 51, 52 in der Schaumummantelung 91 schwerer ist. Dies ist insbesondere dann der Fall, wenn der Kabelbaum 20, beispielsweise als Motorkabelbaum, bei einer Brennkraftmaschine eingesetzt ist oder in anderen heißen Umgebungen des Fahrzeugs.

In einem zweiten Verfahrensschritt 310 wird die Wärme Q (vgl. Figur 2) über die jeweilige Isolierung 60, 70 an die Ummantelung 90, insbesondere die Schaumummantelung 91, übertragen. Von der Ummantelung 90 wird die Wärme Q an den thermoelektrischen Generator 25 weiterübertragen. Der thermoelektrische Generator 25 nimmt die durch den elektrischen Leiter 55, 65 erzeugte Wärme Q zumindest teilweise auf und wandelt die Wärme Q zumindest teilweise in eine zweite elektrische Energie um. Dabei bildet sich eine Spannung zwischen den beiden Anschlusspunkten 126, 127 an der Ausgangsseite 75 des thermoelektrischen Generators 25 aus. Durch die Aufnahme der Wärme Q vom elektrischen Leiter 55, 65 kühlt somit der thermoelektrische Generator 25 den jeweiligen elektrischen Leiter 55, 65 und bildet eine Wärmesenke aus. Durch die Kühlung des elektrischen Leiters 55, 65 wird ferner eine thermische Überhitzung der jeweiligen, an dem elektrischen Leiter 55, 65 angeordneten Isolierung 60, 70 vermieden. Ferner wird eine durch die thermische Belastung bedingte Alterung der Isolierung 60, 70 reduziert.

Die vom thermoelektrischen Generator 25 erzeugte zweite elektrische Energie wird an der Ausgangsseite 75 bereitgestellt und über die erste elektrische Verbindung 140 an die Wandlereingangsseite 80 übertragen.

In einem dritten Verfahrensschritt 315 wandelt der DC-Wandler 45 die an der Wandlereingangsseite 80 anliegende Spannung U1 auf eine an der Wandlerausgangsseite 85 anliegende vordefinierte Ausgangsspannung UA um. Die vordefinierte Ausgangsspannung UA entspricht im Wesentlichen der durch die elektrische Energiequelle 40 bereitgestellten Quellenspannung UQ. Insbesondere kann beispielsweise der DC-Wandler 45 derart geregelt sein, dass der DC-Wandler 45 die Ausgangsspannung UA auf die durch die elektrische Energiequelle 40 bereitgestellte Quellenspannung UQ regelt.

In einem vierten Verfahrensschritt 320 wird die zweite elektrische Energie mit der Ausgangsspannung UA und der Quellenspannung UQ über die zweite elektrische Verbindung 145 an das Leistungsterminal 35 übertragen. Das Leistungsterminal 35 dient beispielsweise als Summierglied, an dem die Quellenenergie und die zweite elektrische Energie zusammengeführt werden. Dabei summiert sich die Quellengenergie und die zweite elektrische Energie zu der ersten elektrischen Energie, die von dem Leistungsterminal 35 in das elektrische Bordnetz 30 eingespeist wird.

Bleibt die über das Bordnetz 30 übertragene elektrische erste elektrische Energie konstant, nimmt durch Zusammenführung der Quellenenergie und der zweiten elektrischen Energie die Quellenenergie um den Wert der zweiten elektrischen Energie ab, sodass dadurch von der elektrischen Energiequelle 40 nur eine um die zweite elektrische Energie reduzierte erste Quellenenergie bei Betrieb des thermoelektrischen Generators 25 bereitgestellt werden muss.

Insbesondere wenn die elektrische Energiequelle 40 ein elektrischer Energiespeicher, beispielsweise ein Hochvoltakku eines vollelektrischen Fahrzeugs ist, wird dadurch eine Entladung des elektrischen Energiespeichers reduziert.

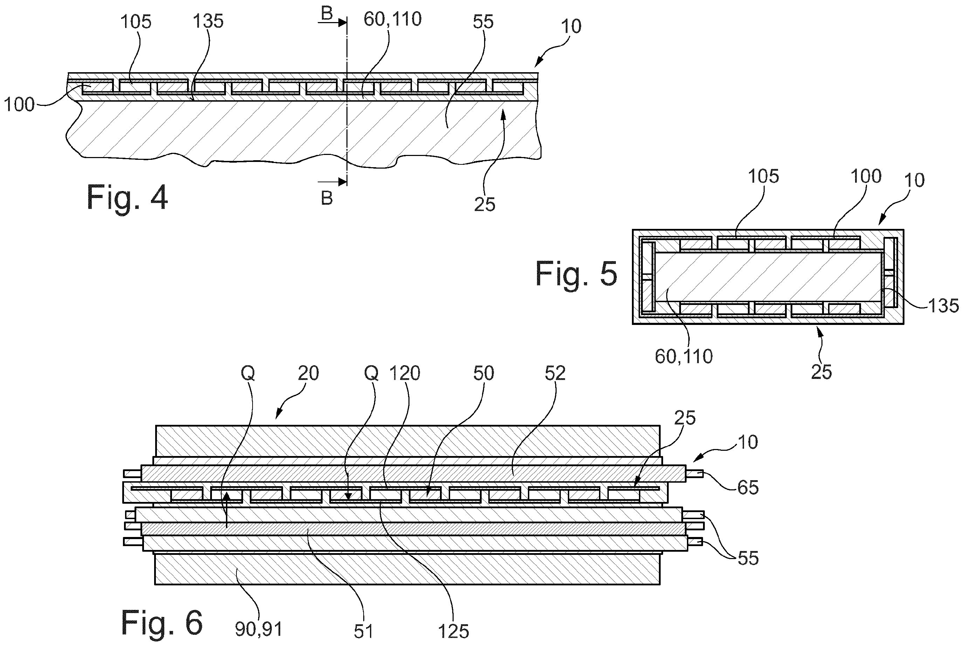

Figur 4 zeigt eine schematische Darstellung eines Längsschnitts durch den ersten elektrischen Leiter 55 und den thermoelektrischen Generator 25 eines Systems 10 gemäß einer zweiten Ausführungsform.

Das System 10 ist im Wesentlichen identisch zu dem in den Figuren 1 bis 2 beschriebenen System 10 ausgebildet. Ebenso kann das in Figur 4 gezeigte System 10 mit dem in Figur 3 beschriebenen Verfahren betrieben werden. Im Folgenden wird ausschließlich auf die Unterschiede des in Figur 4 gezeigten Systems 10 gegenüber dem in den Figuren 1 und 2 gezeigten System 10 eingegangen.

Im Gegensatz zu der in den Figuren 1 und 2 gezeigten Ausgestaltung wird auf das Kabelbündel 50 verzichtet. Stattdessen ist beispielhaft der erste elektrische Leiter 55 als Flachleiter, insbesondere als Busbar oder Batterieleitung, ausgebildet. In der Ausführungsform ist ferner beispielhaft der erste elektrische Leiter 55 aus einem Vollmaterial ausgebildet.

In der Ausführungsform ist beispielhaft der erste elektrische Leiter 55 von dem räumlich versetzt zu dem zweiten elektrischen Leiter 65 angeordnet. Der zweite elektrische Leiter 65 ist in Figur 4 nicht dargestellt, kann aber wie der erste elektrische Leiter 55 ausgebildet sein. Insbesondere kann an dem zweiten elektrischen Leiter 65 ebenso ein weiterer thermoelektrischer Generator 25 angeordnet sein. Der thermoelektrische Generator 25 und der weitere thermoelektrische Generator 25, der am zweiten elektrischen Leiter 65 angeordnet ist, können beispielsweise parallel an der Wandlereingangsseite 80 angeschlossen sein.

Der erste elektrische Leiter 55 weist eine Leiteraußenseite 135 auf. Der thermoelektrische Generator 25 ist an der Leiteraußenseite 135 angeordnet. Der erste elektrische Leiter 55 kann dahingehend gegenüber einer Umgebung elektrisch isoliert sein, dass die erste Trägerschicht 110 und die erste Isolierung 60 einstückig und materialeinheitlich ausgebildet sind. Insbesondere ist von Vorteil, wenn die erste Trägerschicht 110 umfangsseitig vollständig den ersten elektrischen Leiter 55 umschließt.

Figur 5 zeigt eine Schnittansicht entlang einer in Figur 4 gezeigten Schnittebene B-B durch das in Figur 4 gezeigte System 10.

Gegenüber der in Figur 2 gezeigten runden Ausgestaltung des jeweiligen elektrischen Leiters 55, 65 ist in Figur 5 der erste elektrische Leiter 55 mit einem rechteckförmigen Querschnitt ausgestaltet. Um eine elektrische Isolation des ersten elektrischen Leiters 55 gegenüber der Umgebung und gegenüber dem zweiten elektrischen Leiter 65 sicherzustellen, umschließt der thermoelektrische Generator 25 mit der ersten Trägerschicht 110, die beispielhaft einstückig und materialeinheitlich mit der ersten Isolierung 60 ausgebildet ist, umfangsseitig die Leiteraußenseite 135 vollständig. Die rechteckförmige Ausgestaltung des ersten elektrischen Leiters 55 hat ferner den Vorteil, dass die in der Ausführungsform beispielhaft plättchenförmige Ausgestaltung des ersten und/oder zweiten Generatorelements 100, 105 parallel zu der Leiteraußenseite 135 ausgerichtet ist und dadurch eine hohe Wärmeaufnahme der einzelnen Generatorelemente 100, 105 und dadurch eine gute Kühlleistung für den ersten elektrischen Leiter 55 sichergestellt ist.

Figur 6 zeigt einen schematischen Längsschnitt durch einen Kabelabschnitt eines Kabelbaums 20 und den thermoelektrischen Generator 25 eines Systems 10 gemäß einer dritten Ausführungsform.

Das System 10 ist im Wesentlichen identisch zu dem in den Figuren 1 und 2 gezeigten System 10 ausgebildet. Im Folgenden wird ausschließlich auf die Unterschiede des in Figur 6 gezeigten Systems 10 gegenüber dem in den Figuren 1 und 2 gezeigten System 10 eingegangen. Ferner kann das in Figur 6 beschriebene System 10 mit dem in Figur 3 beschriebenen Verfahren betrieben werden.

Das System 10 weicht dahingehend von den Figuren 1 und 2 ab, dass der thermoelektrische Generator 25 vorzugsweise im Verbund des Kabelbündels 50 parallel verlaufend zu den elektrischen Kabeln 51, 52 angeordnet ist. Von besonderem Vorteil ist, wenn der thermoelektrische Generator 25 mit in die Ummantelung 90 eingebettet ist und nahe, vorzugsweise in direktem Kontakt zu dem ersten und/oder zweiten elektrischen Kabel 51, 52 ist. Dadurch ist ein Wärmeübertragungsweg der Wärme Q zwischen dem thermoelektrischen Generator 25 und dem elektrischen Leiter 55, 65 reduziert, sodass auch bei kurzzeitigen Stromspitzen die Wärme von dem thermoelektrischen Generator 25 schnell von dem jeweiligen elektrischen Kabel 51, 52 abgeführt werden kann.

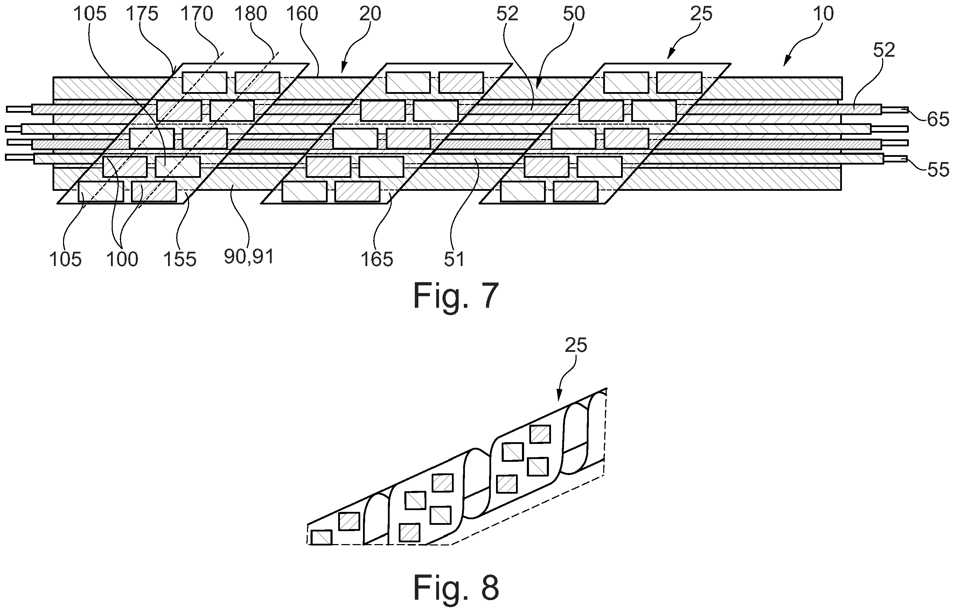

Figur 7 zeigt einen Ausschnitt eines Längsschnitts durch den Kabelbaum 20 mit dem am Kabelbaum 20 angeordneten thermoelektrischen Generator 25 eines Systems 10 gemäß einer vierten Ausführungsform.

Das System 10 ist im Wesentlichen identisch zu dem in den Figuren 1 und 2 erläuterten System 10 ausgebildet. Im Folgenden wird ausschließlich auf die Unterschiede des in Figur 7 gezeigten thermoelektrischen Systems 10 gegenüber dem in den Figuren 1 und 2 gezeigten System 10 gemäß der ersten Ausführungsform eingegangen.

Der thermoelektrische Generator 25 ist in der vierten Ausführungsform des Systems 10 beispielhaft bandförmig ausgebildet. Dabei ist der thermoelektrische Generator 25 beispielhaft um den Kabelbaum 20 gewickelt. Die Wicklung ist beispielhaft derart gewählt, dass eine erste Wicklung 155 des thermoelektrischen Generators 25 beabstandet durch einen Längsspalt 160 zu einer zweiten Wicklung 165 des thermoelektrischen Generators 25 angeordnet ist. Der thermoelektrische Generator 25 kann durch die bandförmige Ausgestaltung in Figur 7 besonders leicht und auch nachträglich auf dem Kabelbaum 20 montiert werden. Zusätzlich kann der thermoelektrische Generator 25 innenseitig mit einer Klebschicht versehen sein, um den thermoelektrischen Generator 25 stoffschlüssig auf dem Kabelbaum 20 zu befestigen.

Selbstverständlich wäre es auch möglich, dass auf den Längsspalt 160 verzichtet wird und die erste und zweite Wicklung 155, 165 aneinanderstoßen. Auch ist eine Überlappung der ersten Wicklung 155 und der zweiten Wicklung 165 möglich. Beispielhaft ist von Vorteil, wenn nur die flexible Leiterplatte 106 der jeweiligen Wicklungen 155, 160 überlappt und eine Überlappung der Generatorelemente 100, 105 vermieden wird.

In der Ausführungsform sind die Generatorelemente 100, 105 in dem bandförmigen thermoelektrischen Generator 25 in wenigstens einer Reihe 170, 180, vorzugsweise parallel verlaufend zu einer Seitenkante 175 des bandförmigen thermoelektrischen Generators 25 angeordnet. Dabei sind in der Reihe 170, 180 die Generatorelemente 100, 105 vorzugsweise abwechselnd zueinander angeordnet. Die Reihenschaltung der Generatorelemente 100, 105 erfolgt beispielsweise entlang der Reihe 170, 180, sodass die erste und zweite Leiterbahn 120, 125 (nicht in Figur 7 dargestellt) ebenso parallel zu der Seitenkante 175 ausgerichtet sein können.

In Figur 7 sind beispielsweise zwei Reihen 170, 180 beabstandet in Kabellängsrichtung in einer Wicklung 155, 165 angeordnet. Dabei kann in Kabellängsrichtung neben dem ersten Generatorelement 100 der ersten Reihe 170 das zweite Generatorelement 105 in der zweiten Reihe 180 angeordnet sein. Ebenso ist umgekehrt das zweite Generatorelement 105 in der ersten Reihe 170 in Längsrichtung neben dem ersten Generatorelement 105 in der zweiten Reihe 180 angeordnet.

Figur 8 zeigt eine schematische Darstellung des in Figur 7 gezeigten thermoelektrischen Generators 25 in demontiertem Zustand.

Der thermoelektrische Generator 25 kann in seiner bandförmigen Ausgestaltung bereits vorgeformt sein, sodass der thermoelektrische Generator 25 schraubenförmig verlaufend ausgebildet ist.

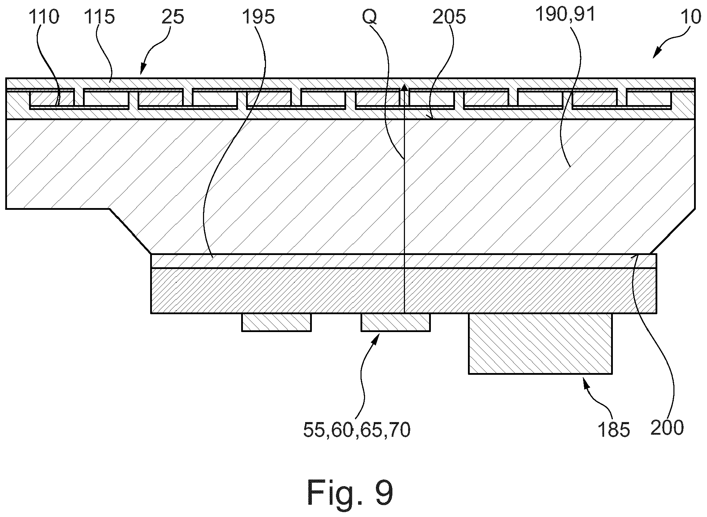

Figur 9 zeigt eine schematische Darstellung eines Systems 10 gemäß einer fünften Ausführungsform.

Das System 10 gemäß der fünften Ausführungsform ist im Wesentlichen identisch zu dem in Figuren 1 und 2 gezeigten System 10 ausgebildet. Im Folgenden wird ausschließlich auf die Unterschiede des in Figur 9 gezeigten Systems 10 gemäß der fünften Ausführungsform gegenüber dem in den Figuren 1 und 2 gezeigten System 10 gemäß der ersten Ausführungsform eingegangen.

Das Bordnetz 30 weist anstatt oder zusätzlich zum oben beschriebenen Kabelbaum 20 beispielhaft eine Leistungselektronik 185 auf. Ferner weist das System 10 ein Gehäuse 190 auf. Das Gehäuse 190 weist vorzugsweise einen thermisch leitfähigen zweiten Werkstoff auf. Von besonderem Vorteil ist, wenn das Gehäuse 190 wenigstens einen der folgenden thermisch leitfähigen zweiten Werkstoffe aufweist: Metall, thermisch leitfähigen Kunststoff, Aluminium, Stahl.

Die Leistungselektronik 185 weist zumindest den ersten elektrischen Leiter 55 auf. Zusätzlich kann die Leistungselektronik 185 die erste Isolierung 60 und/oder den zweiten elektrischen Leiter 65 und/oder die zweite Isolierung 70 aufweisen. Die Leistungselektronik 185 kann beispielsweise Teil eines Steuergeräts und/oder eines Treibers einer Komponente des Fahrzeugs sein.

Der erste elektrische Leiter 55 kann beispielsweise Teil einer Komponente der Leistungselektronik 185 sein. So kann beispielsweise der erste elektrische Leiter 55 beispielsweise Teil einer Komponente der Leistungselektronik 185, beispielsweise eines Leistungstransistors, eines Mosfets oder einer anderen Komponente der Leistungselektronik 185 sein.

Ebenso kann die erste Isolierung 60 Teil der Komponente der Leistungselektronik 185, beispielsweise des Leistungstransistors, des Mosfets und/oder einer anderen Komponente der Leistungselektronik 185 sein. Auch kann der erste elektrische Leiter 55 als Leiterbahn einer Leiterplatte der Leistungselektronik 185 ausgebildet sein. Das für den ersten elektrischen Leiter 55 und die erste Isolierung 60 Erläuterte gilt ebenso auch für den zweiten elektrischen Leiter 65 und die zweite Isolierung 70.

Die Leistungselektronik 185 ist vorzugsweise mittels einer Wärmeleitschicht 195, beispielsweise mittels eines Silberleitklebers, thermisch an einer ersten Seitenfläche 200 des Gehäuses 190 thermisch mit dem Gehäuse 190 verbunden. In Figur 9 ist beispielhaft gegenüberliegend zur ersten Seitenfläche 200 der thermoelektrische Generator 25 mit dem Gehäuse 190 thermisch verbunden. Dabei liegt die Leiterplatte 106 beispielsweise mit der ersten Trägerschicht 110 an der zweiten Seitenfläche 205 an. Der thermoelektrische Generator 25 bedeckt beispielsweise die zweite Seitenfläche 205 zumindest teilweise, vorzugsweise vollständig. Dabei kann der thermoelektrische Generator 25 an der zweiten Seitenfläche 205 im Wesentlichen plattenförmig ausgebildet sein. Das Gehäuse 190 verbindet thermisch den thermoelektrischen Generator 25 mit der Leistungselektronik 185.

Das System 10 kann im Wesentlichen mit dem in Figur 3 beschriebenen Verfahren betrieben werden. Abweichend dazu wird jedoch die Wärme Q von dem elektrischen Leiter 55, 65 über die Isolierung 60, 70 der Leistungselektronik 185 auf die Wärmeleitschicht 195 und von der Wärmeleitschicht 195 auf das Gehäuse 190 und vom Gehäuse 190 auf den thermoelektrischen Generator 25 übertragen. Der thermoelektrische Generator 25 kühlt somit via der Wärmeleitschicht 195 und dem Gehäuse 190 die Leistungselektronik 185. Diese Ausgestaltung hat den Vorteil, dass ein ungewolltes Überhitzen der Leistungselektronik 185 zuverlässig vermieden werden kann.

Die in den Figuren 1 bis 9 beschriebene Ausgestaltung des Systems 10 hat den Vorteil, dass hohe thermische Energieverluste aus dem Bordnetz 30 direkt abgegriffen werden können und die thermischen Energieverluste zumindest teilweise zurückgewonnen werden können und dadurch die Effizienz im System 10 gesteigert werden kann.

Durch die Integration des thermoelektrischen Generators 25 in das System 10, insbesondere durch den Einbau im Bordnetz 30, können die elektrische Leiter 55, 65 unterschiedlich ausgebildet sein und sowohl unterschiedliche geometrische als auch unterschiedliche anwendungsspezifische Ausgestaltungen aufweisen. Durch die Integration des thermoelektrischen Generators 25 in das Bordnetz 30 können auch bei geringen Leitungsverlusten und geringer Erwärmung bereits thermoelektrische Effekte erzielt werden.

### Bezugszeichenliste

- 10: System
- 20: Kabelbaum
- 25: thermoelektrischer Generator
- 30: Bordnetz
- 35: Leistungsterminal
- 40: elektrische Energiequelle
- 45: DC-Wandler
- 50: Kabelbündel
- 51: erstes elektrisches Kabel
- 52: zweites elektrisches Kabel
- 55: erster elektrischer Leiter
- 60: erste Isolierung
- 65: zweiter elektrischer Leiter
- 70: zweite Isolierung
- 75: Ausgangsseite
- 80: Wandlereingangsseite
- 85: Wandlerausgangssseite
- 90: Ummantelung
- 91: Schaumummantelung
- 95: Anordnung
- 100: erstes Generatorelement
- 105: zweites Generatorelement
- 106: flexible Leiterplatte
- 110: erste Trägerschicht
- 115: zweite Trägerschicht
- 120: erste Leiterbahn
- 125: zweite Leiterbahn
- 126: erster Anschlusspunkt
- 127: zweiter Anschlusspunkt
- 128: dritte Leiterbahn
- 129: vierte Leiterbahn
- 130: äußere Umfangsseite der Ummantelung
- 131: Kabelabschnitt
- 135: Leiteraußenseite
- 140: erste elektrische Verbindung
- 145: zweite elektrische Verbindung
- 150: dritte elektrische Verbindung
- 155: erste Wicklung
- 160: Längsspalt
- 165: zweite Wicklung
- 170: erste Reihe
- 175: Seitenkante
- 180: zweite Reihe
- 185: Leistungselektronik
- 190: Gehäuse
- 195: Wärmeleitschicht
- 200: erste Seitenfläche
- 205: zweite Seitenfläche

- 305: erster Verfahrensschritt
- 310: zweiter Verfahrensschritt
- 315: dritter Verfahrensschritt
- 320: vierter Verfahrensschritt

- Q: Wärme

- U1: Spannung an der Ausgangsseite
- UA: vordefinierte Ausgangsspannung
- UQ: Quellenspannung

## Patentansprüche

1. System (10) zur Stromübertragung innerhalb eines Fahrzeugs,
- wobei das System (10) einen thermoelektrischen Generator (25) und ein elektrisches Bordnetz (30) mit wenigstens einem ersten elektrischen Leiter (55) aufweist,
- wobei der thermoelektrische Generator (25) eine Ausgangsseite (75) aufweist, die elektrisch mit einer elektrischen Energiequelle (40) des Fahrzeugs verbindbar ist,
- wobei der thermoelektrische Generator (25) direkt oder indirekt thermisch mit dem ersten elektrischen Leiter (55) verbunden ist,
- wobei der erste elektrische Leiter (55) ausgebildet ist, eine erste elektrische Energie zu übertragen und auf Grund der Übertragung der ersten elektrischen Energie eine Wärme (Q) bereitzustellen,
- wobei der thermoelektrische Generator (25) ausgebildet ist, die Wärme (Q) von zumindest dem ersten elektrischen Leiter (55) aufzunehmen und in eine zweite elektrische Energie umzuwandeln,
- wobei der thermoelektrische Generator (25) ausgebildet ist, die zweite elektrische Energie an der Ausgangsseite (75) zur Einspeisung in das elektrische Bordnetz (30) bereitzustellen.

2. System (10) nach Anspruch 1, insbesondere Kabelbaum (20),
- wobei das Bordnetz (30) einen Kabelbaum (20) mit einem Kabelbündel (50) mit wenigstens einem ersten elektrischen Kabel (51) und einem zweiten elektrischen Kabel (52) aufweist,
- wobei das erste elektrische Kabel (51) den ersten elektrischen Leiter (55) und eine erste Isolierung (60) aufweist, die den ersten elektrischen Leiter (65) elektrisch isoliert,
- wobei das zweite elektrische Kabel (52) einen zweiten elektrischen Leiter (65) zur Stromübertagung und eine zweite Isolierung (70) aufweist, die den zweiten elektrischen Leiter (65) elektrisch isoliert,
- wobei der thermoelektrische Generator (25) sowohl mit dem ersten elektrischen Leiter (55) als auch mit dem zweiten elektrischen Leiter (65) thermisch verbunden und ausgebildet ist, den ersten und zweiten elektrischen Leiter (55, 65) zu kühlen.

3. System (10) nach Anspruch 2,
- aufweisend eine Schaumummantelung (91),
- wobei das Kabelbündel (50) zumindest abschnittsweise, vorzugsweise vollständig, in der Schaumummantelung (91) eingebettet ist,
- wobei die Schaumummantelung (91) mechanisch das erste elektrische Kabel (51) mit dem zweiten elektrischen Kabel (52) verbindet,
- wobei vorzugsweise der thermoelektrische Generator (25) zumindest an einem der elektrischen Kabel (51, 52) des Kabelbündels (50) anliegt und/oder der thermoelektrische Generator (25) zumindest mit einem der elektrischen Kabel (51, 52) des Kabelbündels (50) über die Schaumummantelung (91) verbunden ist.

4. System (10) nach Anspruch 2 oder 3,
- wobei der thermoelektrische Generator (25) bandförmig ausgebildet ist und um das Kabelbündel (50) umfangsseitig herumgeführt, insbesondere gewickelt, ist,
- wobei der thermoelektrische Generator (25) mechanisch das erste elektrische Kabel (51) mit dem zweiten elektrischen Kabel (52) verbindet.

5. System (10) nach einem der vorhergehenden Ansprüche,
- aufweisend einen DC-Wandler (45),
- wobei der DC-Wandler (45) zwischen der Ausgangsseite (75) und dem thermoelektrischen Generator (25) angeordnet ist,
- wobei der DC-Wandler (45) eine Wandlereingangsseite (80) und eine Wandlerausgangsseite (85) aufweist,
- wobei die Wandlereingangsseite (80) elektrisch mit der Ausgangsseite (75) des thermoelektrischen Generators (25) verbunden ist,
- wobei die Wandlerausgangsseite (85) elektrisch mit dem Bordnetz (30) des Fahrzeugs gekoppelt ist,
- wobei der DC-Wandler (45) ausgebildet ist, eine an der Wandlereingangsseite (80) anliegende Spannung (U1) der zweiten elektrischen Energie auf eine an der Wandlerausgangsseite (85) anliegende vordefinierte Ausgangsspannung (UA) zu wandeln.

6. System (10) nach einem der vorhergehenden Ansprüche,
- wobei der thermoelektrische Generator (25) eine Anordnung (95) aus wenigstens einem ersten Generatorelement (100) und einem zweiten Generatorelement (105) aufweist,
- wobei das erste Generatorelement (100) und das zweite Generatorelement (105) unterschiedlich zueinander dotiert sind,
- wobei das erste Generatorelement (100) und das zweite Generatorelement (105) elektrisch in Reihe zueinander geschaltet sind.

7. System (10) nach Anspruch 6,
- wobei der thermoelektrische Generator (25) eine flexible Leiterplatte (106) aufweist,
- wobei wenigstens eine Leiterbahn (120, 125) der flexiblen Leiterplatte (106) das erste Generatorelement (100) mit dem zweiten Generatorelement (105) verbindet.

8. System (10) nach Anspruch 7,
- wobei die flexible Leiterplatte (106) eine erste Trägerschicht (110) und zweite Trägerschicht (115) aufweist,
- wobei die erste Trägerschicht (110) und die zweite Trägerschicht (115) jeweils elastisch und elektrisch isolierend ausgebildet sind,
- wobei zwischen der ersten Trägerschicht (110) und der zweiten Trägerschicht (115) das erste und zweite Generatorelement (100, 105) angeordnet sind.

9. System (10) nach Anspruch 8,
- aufweisend eine erste Isolierung (60)
- wobei die erste Isolierung (60) an dem ersten elektrischen Leiter (55) angeordnet ist und den ersten elektrischen Leiter (55) ummantelt,
- wobei die erste Isolierung (60) einstückig und materialeinheitlich mit der ersten Trägerschicht (110) ausgebildet ist.

10. System (10) nach einem der vorhergehenden Ansprüche,
- wobei der thermoelektrische Generator (25) schlauchförmig und/oder hohlzylinderförmig oder bandförmig ausgebildet ist,
- und/oder
- wobei der erste elektrische Leiter (55) als Flachleiter, insbesondere als Busbar oder Batterieleitung, ausgebildet ist.

11. System (10) nach einem der vorhergehenden Ansprüche,
- wobei der erste elektrische Leiter (55) eine Leiteraußenseite (135) aufweist,
- wobei der thermoelektrische Generator (25) auf der Leiteraußenseite (135) angeordnet ist.

12. System (10) nach einem der Ansprüche 1 bis 10,
- wobei der erste elektrische Leiter (55) eine Leiteraußenseite (135) aufweist,
- wobei die erste Isolierung (60) auf der Leiteraußenseite (135) angeordnet ist und den ersten elektrischen Leiter (55) elektrisch isoliert,
- wobei auf einer vom ersten elektrischen Leiter (55) abgewandten Seite der ersten Isolierung (60) der thermoelektrische Generator (25), vorzugsweise in direktem Kontakt mit der ersten Isolierung, angeordnet ist.

13. System (10) nach einem der vorhergehenden Ansprüche,
- aufweisend ein Gehäuse (190),
- wobei das Bordnetz (30) eine Leistungselektronik (185) aufweist,
- wobei die Leistungselektronik (185) den ersten elektrischen Leiter (55) aufweist,
- wobei das Gehäuse (190) thermisch leitfähig ausgebildet ist und thermisch mit dem ersten elektrischen Leiter (55) und dem thermoelektrischen Generator (25) verbunden ist,
- wobei an dem Gehäuse (190) der thermoelektrische Generator (25) angeordnet ist und das Gehäuse (190) thermisch den ersten elektrischen Leiter (55) mit dem thermoelektrischen Generator (25) verbindet.

14. System (10) nach einem der vorhergehenden Ansprüche,
- aufweisend eine elektrische Energiequelle (40) und ein Leistungsterminal (35), das mit der elektrischen Energiequelle (40) elektrisch verbunden ist,
- wobei die elektrische Energiequelle (40) ausgebildet ist, am Leistungsterminal (35) eine Quellenenergie bereitzustellen,
- wobei der erste elektrische Leiter (55) mit dem Leistungsterminal (35) elektrisch verbunden ist,
- wobei die Ausgangsseite (75) mit dem Leistungsterminal (35) elektrisch gekoppelt ist,
- wobei die zweite elektrische Energie gemeinsam mit der elektrischen Quellenenergie als erste elektrische Energie in den ersten elektrischen Leiter (55) einspeisbar sind.

15. Verfahren zum Betrieb eines Systems (10) nach Anspruch 14,
- wobei über den ersten elektrischen Leiter (55) die erste elektrische Energie übertragen wird,
- wobei der erste elektrische Leiter (55) erwärmt und die Wärme (Q) bereitstellt,
- wobei die Wärme (Q) vom ersten elektrischen Leiter (55) zu dem thermoelektrischen Generator (25) übertragen wird,
- wobei der thermoelektrische Generator (25) die bereitgestellte Wärme (Q) aufnimmt und in die zweite elektrische Energie umwandelt,
- wobei die zweite elektrische Energie in das Bordnetz (30) eingespeist wird.
